# EUROPEAN PATENT APPLICATION

(11) **EP 1 383 363 A2**
(43) Date of publication of application: **21.01.2004**
(21) Application number: 03254451.2
(22) Date of filing: 15.07.2003
(51) Int. Cl.: H05K 1/11

(54) **Circuit board with directly mounted lamps**

(30) Priority: 19.07.2002 GB 0216823
(71) Applicant: Gamesman Limited, Crawley, West Sussex RH10 2QR (GB)
(72) Inventor: Sivacumarran, Karthigesu, New Malden, Surrey KT3 3TB (GB)
(74) Representative: Wilson Gunn M'Caw

(57) **Abstract**

A lamp assembly has one or more lamps (8, 9), particularly LED lamps, with terminals (11) attached to a circuit board (10) so as to be supported by the board. The lamp terminals (11) are connected via conductive pathways (12) to edge contacts (A1, A2, A3, B1, B2, B3) on the board which can be inserted into a lamp holder (1) so that the board (10) is supported by the lamp holder (1) and the edge contacts (A1-3, B1-3) conductively engage electrical contacts (5) in the lamp holder (1). The lamp terminals (11) are attached to positions (13) on the pathways (12) on opposite sides of the board (10) so that the lamp (8, 9) straddles the board, preferably symmetrically. Where there are two or more lamps (8, 9) these are connected to different combinations of pathways (12) and edge contacts (A1-3, B1-3) so that they can be operated independently,

## Description

This invention relates to lamps.

Patent application GB 2370346A discloses a lamp assembly (hereinafter a lamp assembly of the kind described) for use with a lamp holder having a receptacle containing electrical contacts to receive and support the base part of a lamp, which lamp assembly comprises at least one lamp having terminals projecting therefrom, and a circuit board having conductive pathways thereon, the lamp terminals being fixed to respective positions on the pathways so as to establish electrical contact therebetween and such that the lamp is physically supported by the circuit board, characterised in that the board has an edge region thereto for insertion into said lamp holder receptacle so as to be supported thereby, and said pathways include mutually spaced conductive portions at said edge region for conductive engagement with said contacts within said lamp holder receptacle.

As specifically described in the above mentioned patent application, the lamp may be an LED and the circuit board may be a printed circuit board.

Lamp assemblies of the kind described may be used in entertainment machines of the coin-operated AWP (amusement with prizes), or SWP (skill with prizes) or gaming kind (referred to as fruit machines or poker machines or slot machines), for back illumination of transparent or translucent display structures such as front glass panels and press buttons.

In order to facilitate desired location of the lamp within a button or other receiving structure it is advantageous for the lamp to be mounted on the circuit board centrally with regard to the mid plane of the board. With this arrangement it can be more readily ensured that the lamp will be in a predetermined central location relative to the button or other receiving structure, even where there is the possibility of inserting the board different ways round into the lamp holder. This is especially important in the case where the lamp is an LED which is located within or behind a central lens structure.

GB 23341 52A describes a lamp assembly having an LED centrally mounted on the end of a printed circuit board for mounting in an instrument panel. However this central mounting is achieved by specially forming terminals of the LED to hold the LED centrally whilst connecting the terminals asymmetrically at one side only of the board. This therefore involves inconvenient and expensive manufacturing procedures.

An object of the present invention is to enable the lamp to be mounted centrally in simple and convenient manner.

According to one aspect of the invention therefore there is provided a lamp assembly of the kind described characterised in that said pathways are provided on opposite sides of the board, and the lamp terminals are fixed to said positions respectively on said opposite sides.

With this arrangement it is possible to mount the lamp so that it straddles the board and can therefore be readily disposed in a desired central disposition, and this can be achieved in a particularly simple and convenient manner in so far as special formation of the terminals is not required.

In a particularly preferred embodiment the lamp is mounted symmetrically with regard to the mid plane of the board. Thus where the lamp has a generally cylindrical body the mid plane of the board may contain the lamp body axis.

There may be a single lamp, or multiple lamps all of which may straddle the board as described.

Where multiple lamps are provided these may be independently operable to provide enhanced display capabilities. This may be achieved by connection of the lamps to different combinations of pathways leading to different combinations of conductive portions and hence different combinations of contacts within the lamp holder receptacle.

Thus and in accordance with a second aspect of the invention which may be combined with the first aspect of the invention, there is provided a lamp assembly of the kind described having a plurality of said lamps arranged for operation independently of each other, characterised in that the lamps are connected to different combinations of said pathways leading to different combinations of said conductive portions.

With this arrangement different display effects can be achieved by differential operation of the lamps.

The arrangement may be such that each said lamp can be independently operated by supply of operating power to the respective said combination of conductive portions.

At least one lamp may have at least one terminal connected to a conductive portion unique to that lamp, and a plurality of lamps may have at least one terminal connected to a common conductive portion.

In a particularly preferred embodiment there are two independently operated lamps although other numbers of lamps may also be used. With two lamps there may be three conductive portions.

Preferably, with either aspect of the invention, the lamps are LEDs and the lamp terminals are projecting wires.

Preferably also the lamp terminals are soldered to the pathway positions, and the circuit board is preferably a printed circuit board.

The circuit board may include circuitry adapted to enable the board to be connected to the lamp holder without requiring conformation to a desired connection mode e.g. such that different polarizations of connection are possible.

Thus, in the case where the lamps require connection to d.c. supply of a predetermined polarity the circuitry may comprise a diode bridge arrangement which accommodates either of two opposite polarities of interconnections between the board and the lamp holder.

The circuit board may be of any suitable shape. In a preferred embodiment the board is of a generally rectangular shape with the lamps projecting at one end, and the conductive portions at the opposite end region.

The circuit board may be generally symmetrical about a longitudinal axis, especially in the case where it is intended to be inserted into the lamp holder in either of two different configurations e.g. either way round rotated through 180° about the longitudinal axis.

Alternatively, in the case where connection in different configurations is not required, the board may be asymmetrical, e.g. stepped as described in GB 2370346A, so that it can only be inserted into the lampholder in one configuration e.g. one way round.

The conductive portions may be applied to both opposite faces of the board with connections therebetween through the board.

Where multiple lamps are provided these may be disposed symmetrically with regard to each other relative to the central longitudinal axis of the board e.g. one on each side of the central axis where there are two lamps.

The lamp assembly of the invention is particularly suitable for use in a press button of an entertainment machine as described above. However the assembly may be used in other contexts.

The invention will now be described further by way of example only and with reference to the accompanying drawings in which:
- Figure 1: is a diagrammatic perspective view of a lamp holder for use with one form of a lamp assembly according to the invention, shown partially cut away;
- Figures 2a, 2b, 2c: are views from opposite faces and one side edge of the lamp assembly; and
- Figure 3: is a circuit diagram of the assembly.

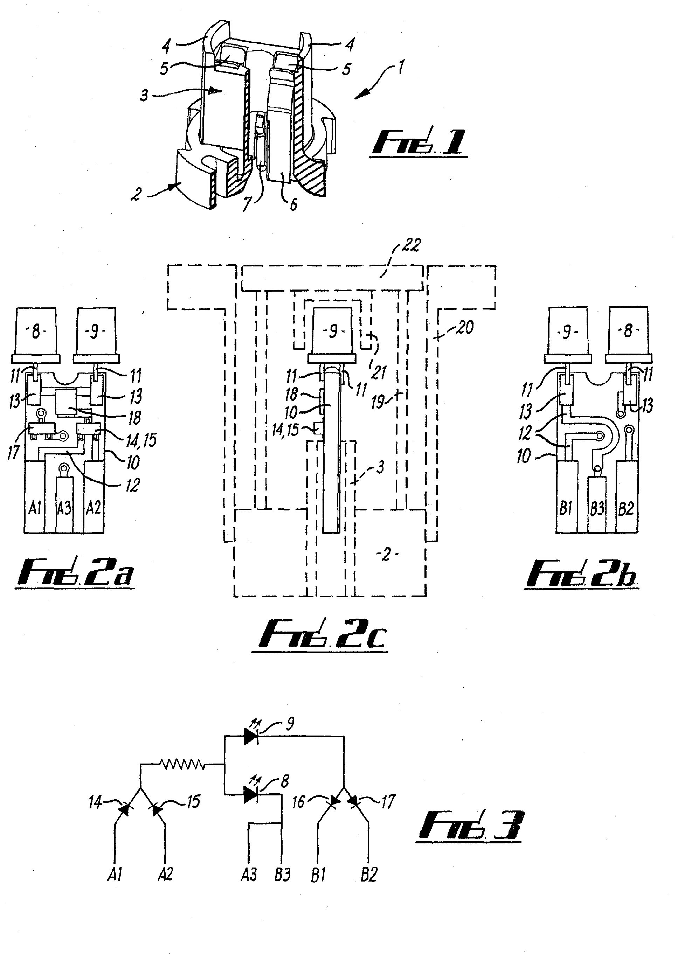

Referring to the drawings. Figure 1 shows a lamp holder 1, such as may be used with a conventional filament bulb. The holder has a moulded plastics body which provides a generally ring-shaped collar 2 with a central upstanding tubular receptacle 3 of generally rectangular cross-section with outwardly convexly curved narrow end walls 4.

The tubular receptacle 3 is open-ended and has a central axis coincidental with the axis of the collar 2.

The receptacle 3 contains electrical socket contacts 5 which are spaced apart and are located respectively adjacent the curved end walls 4. These contacts 5 have upwardly open springy metal jaws connected to integral connection members 6 which project from the bottom end of the receptacle 3. Adjacent the bottom end region of the receptacle 3 there are opposed springy metal contact fingers 7 (only one shown) between the socket contacts 5.

Figures 2a-c show a lamp assembly comprising two LEDs 8, 9 and a printed circuit board 10.

The LEDs 8, 9 are generally cylindrical and each has, at its bottom end, a pair of externally projecting terminal wires 11.

The printed circuit board 10 is generally rectangular with straight side and bottom edges. The top edge is straight except for a central cut away portion.

Conductive pathways 12 are established on both opposite faces of the board 10 with connections therebetween through the board.

At each face there are three rectangular conductive pads A1, A2, A3 and B1, B2, B3 extending at the bottom region up to the bottom end edge and to the adjacent side edges. There are two outer like pads A1, A2, and B1, B2 and one central shorter pad A3, B3. The pads on one face are superimposed relative to the pads on the opposite face i.e. A1 on B2, A2 on B1, A3 on B3.

At each face there are two outer rectangular conductive pads 13 extending at the top region up to the top end edge. The pads 13 on one face are superimposed relative to the pads 13 on the opposite face.

The central conductive pads A3, B3 on opposite faces are linked to each other through the board 10. There are components mounted on one face of the board, namely four diodes 14, 15, 16, 17 and one resistor 18.

The bottom conductive pads A1-A3, B1-B3 on each face are connected via circuitry established by the pathways 12 and the components 14-18 to the top pads 13.

The two LEDs 8, 9 are mounted on the top end region of the board 10 by soldering of the terminals 11 to the top pads 13. That is, the terminals 11 of each LED 8, 9 are soldered respectively to each pair of superimposed contact pads 11. The LED 8, 9 is thereby physically supported by the printed circuit board 10 and projects beyond the top end edge.

The arrangement is such that each LED 8, 9 straddles the board 10 with the central longitudinal axis of the body of the lamp 8, 9 contained in the mid plane of the board 10.

The two LEDs 8, 9 are disposed equidistant from the central longitudinal axis of the board 10.

The LEDs are therefore disposed individually symmetrically relative to the mid plane of the board, and symmetrically with regard to each other relative to the central axis of the board.

In use, the circuit board is plugged into the lamp holder 1 by pushing the bottom end region of the board 10 into the jaws of the socket contacts 5. The board can be pushed down until the central conductive pads A3, B3 engage the finger contacts 7 and the top end region of the board and the LEDs project beyond the top end of the receptacle 3. The pads A1, A2, B1, B2 conductively engage the contacts 5.

The board 10 is thereby held in position, in like manner to a filament lamp, with the conductive pads A1-A3, B1-B3 connected to the contacts 5, 7 in the lamp holder 1.

The circuitry on the board acts to connect the LEDs 8, 9 to the conductive pads A1-A3, B1-B2 through different combinations of connections. That is, one LED 8 is connected between the central conductive pads A3, B3 and the two outer conductive pads A1, A2 on one face via two diodes 14, 15, and the other LED 9 is connected between these two outer pads A1, A2 and the two outer pads B1, B2 on the other face.

In use, the central conductive pads A3, B3 are connected, via the finger contacts 7, to negative supply, and the two outer pairs of superimposed conductive pads A1, B2 and A2, B1 are connected via the socket contacts 5 respectively to positive and negative supply.

Due to the location of the linked central pads A3, B3 symmetrically with regard to the central axis of the board 10, whichever way round the board is inserted into the receptacle, these pads A3, B3 and hence the negative side of the LED 8 will always be connected to negative supply.

Due to the arrangement of the diodes 14-17 the negative side of the LED 9 will always be connected to negative supply via one or other of the diodes 16, 17, and to positive supply via one or other of the other diodes 14, 15.

With this arrangement, the LEDs 8, 9 will operate in the same way whichever way round the board 10 is inserted into the receptacle.

Also, the two diodes 8, 9 can be operated independently by control of negative supply. That is, the diode 8 can only operate if negative supply is connected to the central pads A3, B3 and the diode 9 can only operate if negative supply is connected to one of the pairs of pads A1, B2 or A2, B1.

The arrangement of the LEDs 8, 9 symmetrically on the top end edge of the board 10 facilitates precise location of the lamps, whichever way round the board 10 is inserted into the receptacle 3, with regard to a diffuser or lens system or transparent or translucent cover into or behind which the lamp assembly is mounted.

By way of example, as shown in broken lines in Figure 2c, the lamp assembly may be inserted into a push-button structure comprising a displaceable tubular body 19 within an outer sleeve structure 20 with a lens 21 and a translucent cap 22. The sleeve structure 20 is releasably attached to the collar 2, and by application of pressure to the cap 22 the tubular body 19 can move down to operate a microswitch (not shown). With the arrangement described it can be ensured that the LEDs 8, 9 are accurately aligned with the lens 21 and cap 22.

The lamp assembly is therefore particularly easy and convenient to install accurately yet is simple and inexpensive to manufacture;

It is of course to be understood that the invention is not intended to be restricted to the details of the above embodiments which are described by way of example only.

## Claims

1. A lamp assembly for use with a lamp holder having a receptacle containing electrical contacts to receive and support the base part of a lamp, which lamp assembly comprises at least one lamp (8, 9) having terminals (11) projecting therefrom, and a circuit board (10) having conductive pathways (12) thereon, the lamp terminals (11) being fixed to respective positions on the pathways (12) so as to establish electrical contact therebetween and such that the lamp is physically supported by the circuit board, and wherein the board has an edge region thereto for insertion into said lamp holder receptacle so as to be supported thereby, and said pathways (12) include mutually spaced conductive portions (A1-3, B1-3) at said edge region for conductive engagement with said contacts within said lamp holder receptacle **characterised in that** said pathways (12) are provided on opposite sides of the board (10), and the lamp terminals (11) are fixed to said positions (13) respectively on said opposite sides.

2. A lamp assembly according to claim 1 **characterised in that** the lamp (8, 9) is mounted symmetrically with regard to the mid plane of the board (10).

3. A lamp assembly according to claim 2 wherein the lamp (8, 9) has a generally cylindrical body **characterised in that** the mid plane of the board (10) contains the lamp body axis.

4. A lamp assembly according to any one of claims 1 to 3 **characterised in that** there are multiple lamps (8, 9).

5. A lamp assembly according to claim 4 **characterised in that** the lamps (8, 9) are disposed symmetrically with regard to each other relative to the central longitudinal axis of the circuit board (10).

6. A lamp assembly according to claim 4 or 5 **characterised in that** the lamps (8, 9) are independently operable.

7. A lamp assembly according to claim 6 **characterised in that** the lamps are connected to different combinations of pathways (12) leading to different combinations of conductive portions (A1-3, B1-3).

8. A lamp assembly for use with a lamp holder having a receptacle containing electrical contacts to receive and support the base part of a lamp, which lamp assembly comprises at least one lamp (8, 9) having terminals (11) projecting therefrom, and a circuit board (10) having conductive pathways (12) thereon, the lamp terminals (11) being fixed to respective positions on the pathways (12) so as to establish electrical contact therebetween and such that the lamp is physically supported by the circuit board, and wherein the board has an edge region thereto for insertion into said lamp holder receptacle so as to be supported thereby, and said pathways (12) include mutually spaced conductive portions (A1-3, B1-3) at said edge region for conductive engagement with said contacts within said lamp holder receptacle, said assembly having a plurality of said lamps (8, 9) arranged for operation independently of each other, **characterised in that** the lamps (8, 9) are connected to different combinations of said pathways (12) leading to different combinations of said conductive portions (A1-3, B1-3).

9. A lamp assembly according to claim 7 or 8 **characterised in that** at least one lamp (8) has at least one terminal (11) connected to a conductive portion (A3, B3) unique to that lamp, and a plurality of lamps (8, 9) has at least one terminal connected to a common conductive portion (A1, A2, B1, B2).

10. A lamp assembly according to any one of claims 7 to 9 **characterised in that** there are two independently operable lamps (8, 9) connected to three conductive portions (A1-A3, B1-B3).

11. A lamp assembly according to any one of claims 1 to 10 **characterised in that** the lamp (8, 9) is an LED and the lamp terminals (11) are projecting wires.

12. A lamp assembly according to any one of claims 1 to 11 **characterised in that** the lamp terminals (11) are soldered to the pathway positions (12), and the circuit board (10) is a printed circuit board.

13. A lamp assembly according to any one of claims 1 to 12 **characterised in that** the circuit board includes circuitry (14, 15, 16, 17) to permit connection to the lamp holder with different polarizations.

14. A lamp assembly according to claim 13 **characterised in that** the circuitry comprises a diode bridge arrangement (14, 15, 16, 17) which accommodates either of two opposite polarities.

15. A lamp assembly according to any one of claims 1 to 14 **characterised in that** the circuit board (10) is of a generally rectangular shape with the lamp (8, 9) projecting at one end and the conductive portions (A1-A3, B1-B3) at the opposite end region.

16. A lamp assembly according to any one of claims 1 to 15 **characterised in that** the circuit board (10) is generally symmetrical about a horizontal axis.

17. A lamp assembly according to any one of claims 1 to 16 **characterised in that** the conductive portions (A1-A3, B1-B3) are applied to both opposite faces of the board with connections therebetween through the board (10).

18. A lamp assembly according to any one of claims 1 to 17 used in a press button of an entertainment machine.
